# EUROPÄISCHE PATENTSCHRIFT

(11) **EP 0 406 599 B1**
(45) Veröffentlichungstag und Bekanntmachung des Hinweises auf die Patenterteilung: **01.06.1994**
(21) Anmeldenummer: 90111291.2
(22) Anmeldetag: 15.06.1990
(51) Int. Cl.: G03F 7/028, C08L 75/16, C08L 51/08, C08F 283/00

(54) **Photopolymerisierbares Gemisch und daraus hergestelltes Aufzeichnungsmaterial**
Photopolymerisable composition and recording material produced therefrom
Composition photopolymérisable et matériau d'enregistrement produit de cela

(30) Priorität: 21.06.1989 DE 3920229
(43) Veröffentlichungstag der Anmeldung: 09.01.1991
(73) Patentinhaber: HOECHST AKTIENGESELLSCHAFT, 65926 Frankfurt am Main (DE)
(72) Erfinder: Müller-Hess, Waltraud, Dr., D-6200 Wiesbaden (DE); Mohr, Dieter, Dr., D-6501 Budenheim (DE); Rauterkus, Karl-Josef, Dr., D-6233 Kelkheim (DE); Kroggel, Matthias, Dr., D-6233 Kelkheim (DE)

(56) Entgegenhaltungen:
- DE-A- 2 739 774
- DE-A- 3 732 089
- DE-A- 3 835 840
- DERWENT ACCESSION NO. 87-339 611, Questel Telesystems (WPIL), Derwent Publications Ltd., London, GB

## Beschreibung

Die Erfindung betrifft ein in wäßrigen Lösungen entwickelbares photopolymerisierbares Gemisch, das ein polymeres Bindemittel, eine polymerisierbare Verbindung mit mindestens einer ethylenisch ungesättigten Doppelbindung im Molekül sowie einen Photoinitiator bzw. ein Photoinitiatorsystem enthält und das zur Herstellung von lichtempfindlichen Aufzeichnungsmaterialien, insbesondere von Flachdruckplatten und Photoresists geeignet ist.

Aus der DE-B 15 22 362 und der DE-A 19 17 917 sind photopolymerisierbare Gemische bekannt, die wasserlösliche Bindemittel enthalten. Diese Gemische lassen sich zwar in der Regel sehr leicht und schleierfrei entwickeln, sie haben jedoch den Nachteil, daß beim Flachdruck die gehärteten Bildstellen, die das wasserlösliche Bindemittel enthalten, leichter vom Feuchtwasser benetzt und im Verlauf höherer Druckauflagen davon angegriffen werden.

Gemische dieser Art sind auch in der DE-A 20 53 363 beschrieben. Sie enthalten als Bindemittel Umsetzungsprodukte aus einem Hydroxyl- oder Aminogruppen enthaltenden Polymeren und mindestens einem gesättigten Alkyl-, Alkoxy-, Aryl- oder Aryloxy-sulfonylisocyanat. Das Bindemittel wird in Kombination mit Diazoniumsalz-Kondensationsprodukten oder photopolymerisierbaren Gemischen zu lichtempfindlichen Schichten verarbeitet. Die dabei erhaltenen Gemische lassen sich allerdings nur dann wäßrig-alkalisch entwickeln, wenn die eingesetzten Bindemittel hohe Säurezahlen aufweisen, wodurch die Abriebbeständigkeit und auch die Druckeigenschaften der gehärteten Schichten nachteilig beeinflußt werden.

In der EP-A 167 963 wird ein negativ arbeitendes lichtempfindliches Gemisch beschrieben, das zur Herstellung von Flachdruckplatten geeignet ist und das ein Diazoniumsalz-Polykondensationsprodukt, eine radikalisch polymerisierbare ethylenisch ungesättigte Verbindung, einen Photoinitiator und ein wasserunlösliches polymeres Bindemittel enthält. Hohe Druckauflagen werden dabei mit Polyvinylacetalen als Bindemittel erzielt, wobei aber zur Entwicklung Lösungen erforderlich sind, die vorwiegend aus organischen Lösemitteln bestehen.

In der DE-A 37 32 089 werden Pfropfpolymerisate beschrieben, die aus einem Polyurethan als Pfropfgrundlage und aufgepfropften Vinylestereinheiten bestehen, die mindestens teilweise zu Vinylalkoholeinheiten verseift sind. Die Polieren werden als Bindemittel für Pigmente, zur Herstellung von Druckfarben, von Schmelzklebern, von lösemittelhaltigen Klebstoffen, als Bestandteil von Lacken oder Beschichtungsmitteln für Fasern, Folien und Metalle und für thermoplastische Formkörper eingesetzt.

In der JP-A 246047/87 werden photopolymerisierbare Gemische beschrieben, die als Bindemittel Pfropfmischpolymerisate aus Polyurethanen und Polyvinylalkohol mit Mercaptogruppen enthalten.

In der älteren deutschen Patentanmeldung P 38 35 840.9 werden Pfropfpolymerisate beschrieben, die aus den in der DE-A 37 32 089 beschriebenen Pfropfpolymerisaten durch Acetalisieren mit Aldehyden erhalten wurden.

In der älteren deutschen Patentanmeldung P 38 24 146.3 werden lichthärtbare elastomere Gemische beschrieben, die eine radikalisch polymerisierbare Verbindung, einen Photoinitiator und als Bindemittel ein in Wasser oder einer wäßrigen Lösung lösliches oder dispergierbares Pfropfpolymerisat gemäß der DE-A 37 32 089 enthalten.

Aufgabe der Erfindung war es, ein photopolymerisierbares Gemisch vorzuschlagen, das für die Herstellung von Druckplatten, insbesondere Flackdruckplatten, oder von Photoresists geeignet ist, das alle Vorzüge der bekannten photopolymerisierbaren Gemische aufweist, das sich mit praktisch lösemittelfreien wäßrigen Lösungen entwickeln läßt, ohne bei der Verarbeitung mit Leitungswasser enthaltenden Entwicklerlösungen störende Abscheidungen zu ergeben, und das zugleich Druckplatten mit hoher Lichtempfindlichkeit, guter Bildauflösung, hoher Auflage und guter Farbannahme sowie mit hoher Lagerfähigkeit ergibt, wie sie bisher nur mit solchen Druckplatten erreichbar waren, die zur Entwicklung den Zusatz von größeren Mengen organischer Lösemittel erforderten.

Erfindungsgemäß wird ein photopolymerisierbares Gemisch vorgeschlagen, das als wesentliche Bestandteile
a) ein polymeres Bindemittel mit wiederkehrenden Vinylacetaleinheiten,
b) eine radikalisch polymerisierbare Verbindung mit mindestens einer endständigen ethylenisch ungesättigten Gruppe und einem Siedepunkt bei Normaldruck oberhalb 100 °C und
c) eine Verbindung oder eine Verbindungskombination enthält, die unter Einwirkung von aktinischem Licht die Polymerisation der Verbindung (b) einzuleiten vermag.

Das erfindungsgemäße Gemisch ist dadurch gekennzeichnet, daß das Bindemittel ein Pfropfmischpolymerisat ist, dessen Pfropfgrundlage ein Polyurethan mit aufgepfropften Ketten ist, die Vinylalkohol- und Vinylacetaleinheiten enthalten.

Erfindungsgemäß wird ferner ein photopolymerisierbares Aufzeichnungsmaterial aus einem Schichtträger und einer photopolymerisierbaren Schicht vorgeschlagen, das dadurch gekennzeichnet ist, daß die photopolymerisierbare Schicht aus dem vorstehend definierten Gemisch besteht.

Die in dem erfindungsgemäßen Gemisch enthaltenen Pfropfmischpolymerisate sind als solche in der älteren deutschen Patentanmeldung P 38 35 840.9 beschrieben. Zu ihrer Herstellung wird auf eine Pfropfgrundlage aus einem Polyurethan ein Carbonsäurevinylester und ggf. eine weitere damit copolymerisierbare ethylenisch ungesättigte Verbindung aufgepfropft und danach ganz oder teilweise verseift. Die dabei erhaltenen Polymeren mit Vinylalkoholeinheiten werden weiter mit Aldehyden zu Polyvinylacetalen umgesetzt.

Der Mengenanteil der aufgepfropften Komponenten beträgt im allgemeinen 10 bis 95, vorzugsweise 30 bis 90 und insbesondere 40 bis 80 Gew.-%, bezogen auf das gesamte Pfropfpolymerisat.

Die Pfropfgrundlagen bestehen aus Polyurethanen mit mindestens zwei Urethangruppen im Molekül, wobei die Anzahl der Urethangruppen pro Molekül nach oben keiner besonderen Begrenzung unterliegt und im allgemeinen höhere Werte als 2 hat.

Die als Pfropfgrundlage eingesetzten Polyurethane lassen sich nach üblichen Verfahren der Polyurethansynthese aus Diolen und Diisocyanaten herstellen. Prinzipiell sind alle bei der Polyurethansynthese üblicherweise verwendeten Diole einsetzbar. Bevorzugt werden cycloaliphatische Diole, wie Cyclohexandiole, sowie insbesondere aliphatische Diole mit 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere; besonders bevorzugt werden Polyethylenoxide, insbesondere solche mit Molekulargewichten zwischen 200 und 10 000, insbesondere zwischen 400 und 1500. Die Polyetherdiole werden mit Vorteil in Kombination mit niedermolekularen aliphatischen Diolen, z. B. 1,4-Butandiol, 1,3-Propandiol, Ethylenglykol, Diethylenglykol, 1,2-Hexandiol, 1,2-Propandiol, Pentandiol oder Cyclohexandiol eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten können aromatische Diisocyanate eingesetzt werden. Bevorzugt werden aliphatische und/oder cycloaliphatische Diisocyanate. Bevorzugte aliphatische Diisocyanate sind solche mit 2 bis 12 C-Atomen im aliphatischen Rest, z. B. Ethylendiisocyanat, Propylendiisocyanat, Tetramethylendiisocyanat, 2,2,4-Trimethyl-hexamethylendiisocyanat. Bevorzugte cycloaliphatische Diisocyanate sind z. B. 1,4-Diisocyanato-cyclohexan, Dicyclohexylmethan-4,4′-diisocyanat und Isophorondiisocyanat. Besonders bevorzugt werden Hexamethylendiisocyanat und Isophorondiisocyanat.

Das Molverhältnis von Diol- zu Diisocyanatkomponente liegt vorzugsweise zwischen 1 : 0,99 und 1 : 0,5, insbesondere zwischen 1 : 0,98 und 1 : 0,7. Die mittleren Molekulargewichte der Polyurethane liegen vorzugsweise zwischen 200 und 100 000, insbesondere zwischen 1 000 und 50 000, besonders bevorzugt zwischen 3 000 und 25 000.

Zum Pfropfen auf das Polyurethan werden Carbonsäurevinylester mit 3 bis 20, vorzugsweise 4 bis 14 C-Atomen eingesetzt. Besonders bevorzugt werden Vinylacetat und/oder Vinylpropionat, insbesondere Vinylacetat. Bevorzugt werden ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Vinylcarbonsäureestern pfropfen, vorzugsweise Gemische aus Vinylacetat und kleineren Mengen Vinylversatat.

Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein. Weiterhin können die Carbonsäurevinylester auch zusammen mit anderen ethylenisch ungesättigten und copolymerisierbaren Monomeren, insbesondere Säuren, wie Maleinsäure, Itaconsäure, Mesaconsäure, Crotonsäure, Acrylsäure, oder deren Estern, gepfropft werden.

Die erhaltenen Pfropfpolymerisate lassen sich durch Hydrolyse, Alkoholyse oder Umesterung in teil- oder vollverseifte Produkte überführen, wobei der Hydrolysegrad mindestens 30 mol-%, vorzugsweise 45 bis 99 mol-%, bezogen auf die Molzahl verseifbarer Monomereinheiten im Pfropfpolymerisat, beträgt. Die Herstellung der Pfropfpolymerisate mit Polyurethan-Pfropfgrundlage ist in der DE-A 37 32 089 beschrieben.

Die verseiften Pfropfpolymerisate lassen sich im sauren Medium nach bekannten Methoden acetalisieren.

Zur Acetalisierung werden aliphatische C₁- bis C₂₀-Aldehyde, die substituiert sein können, und aromatische Aldehyde, die ebenfalls substituiert sein können, eingesetzt. Bevorzugt werden aliphatische Aldehyde mit 1-5 C-Atomen, z. B. n-Butyraldehyd, Isobutyraldehyd, Propionaldehyd oder Formaldehyd. Ggf. substituierte Benzaldehyde, z. B. Benzaldehyd, p-Chlorbenzaldehyd oder p-Methoxy-benzaldehyd, sind ebenfalls geeignet. Es können auch Kombinationen dieser Aldehyde untereinander verwendet werden.

Der Acetalisierungsgrad der erfindungsgemäß als Bindemittel eingesetzten Pfropfpolyvinylacetale liegt vorzugsweise in einem solchen Bereich, daß der Gehalt an nicht acetalisierten Polyvinylalkoholeinheiten in den Pfropfpolyvinylacetalen bevorzugt 18 bis 60 mol-% und besonders bevorzugt 20 bis 45 mol-% beträgt, jeweils bezogen auf die molare Menge an Vinylalkoholeinheiten in den eingesetzten verseiften Pfropfpolymerisaten, wobei bis zu 55 mol-%, bezogen auf die ursprüngliche Menge, noch als Vinylestereinheiten vorliegen können. Die Hydroxylzahl des fertigen Bindemittels sollte im Bereich von 100 bis 600, vorzugsweise von 200 bis 500 liegen.

Die Acetalisierung kann nach zwei Verfahren erfolgen:
Bei der ersten Ausführungsform wird das Pfropfpolymere in einem Alkohol oder Wasser-Alkohol-Gemisch gelöst oder dispergiert, mit einer katalytischen Menge einer anorganischen oder organischen Säure und einem Aldehyd oder Aldehydgemisch versetzt und erwärmt. Die erhaltene Polymerlösung, die gegebenenfalls ein Antioxidationsmittel enthält, kann direkt zur Herstellung der erfindungsgemäßen Gemische eingesetzt werden, oder das Polymere kann durch Eintropfen in einen Nichtlöser ausgefällt und gereinigt werden.

Bei der zweiten Ausführungsform wird das Pfropfpolymere in Wasser gelöst und mit einem Aldehyd oder Aldehydgemisch versetzt. Dann wird bei niedriger Temperatur eine wäßrige Lösung einer anorganischen oder starken organischen Säure, gegebenenfalls unter Zusatz eines Netzmittels, und eines Antioxidationsmittels zugetropft. Dabei fällt das acetalisierte Pfropfpolymere häufig aus. Die Reaktion wird bei erhöhter Temperatur (etwa 20 - 60°C) vervollständigt. Das isolierte Polymere wird durch Waschen mit Wasser oder durch Umfällen gereinigt.

Zur Herstellung der Pfropfpolyvinylacetale in wäßrigem Medium werden nach bekannten Methoden vorzugsweise 1 bis 50, insbesondere 5 bis 20 gew.-%ige, wäßrige Lösungen der Pfropfpolyvinylalkohole vorzugsweise in der Wärme hergestellt, der Säurekatalysator zugesetzt, die Lösungen anschließend auf Temperaturen unterhalb 25 °C abgekühlt und die Acetalisierungsreaktion durch Zudosieren des Aldehyds, vorzugsweise innerhalb von 3 bis 300 Minuten, unter starkem Rühren durchgeführt. Wegen des bekanntermaßen meist nicht vollständigen Aldehydumsatzes wird im allgemeinen mit Aldehydüberschuß, bevorzugt 10 bis 20 mol-%igem Überschuß, gearbeitet.

In einer bevorzugten Verfahrensvariante wird die wäßrige Lösung vor dem Reaktionsbeginn bei Temperaturen von 0 bis 5 °C mindestens 30 Minuten stehengelassen und dann in Gang gesetzt, wonach sich das gebildete Pfropfpolyvinylacetal alsbald meist pulverförmig abscheidet. Zur Vervollständigung der Reaktion wird das Reaktionsgemisch langsam auf Raumtemperatur erwärmt, und es wird gegebenenfalls eine ca. 1 bis 3 Stunden dauernde Nachreaktion bei höheren Temperaturen, z. B. bei 25 bis 70 °C, angeschlossen. Die zu verwendende Menge Säurekatalysator richtet sich u. a. nach dem angestrebten Acetalisierungsgrad und kann vorzugsweise bis zu 1,1 mol, bezogen auf den molaren Gehalt an Vinylalkoholeinheiten, betragen.

Das gebildete Pfropfpolyvinylacetal wird abgesaugt, mit schwach alkalisch eingestelltem Wasser (pH 9 bis 12) gewaschen und getrocknet. Acetalisierungsprodukte, die sich aus der wäßrigen Reaktionslösung nicht abscheiden, können nach Zusatz von Fällungsmitteln isoliert, gereinigt und getrocknet werden.

Die Acetalisierung kann auch in organischen Lösemitteln durchgeführt werden. Als Lösemittel eignen sich mit Wasser mischbare Lösemittel, insbesondere wasserlösliche Alkohole, z. B. Ethanol und/oder Methanol, ggf. unter Zusatz von Wasser.

Als Säurekatalysatoren werden vorzugsweise organische Sulfonsäuren, z. B. Toluolsulfonsäuren, ferner Mineralsäuren, z. B. Schwefelsäure, Phosphorsäure, Salzsäure oder gegebenenfalls Salpetersäure, verwendet. Phosphorsäure und Salzsäure werden bevorzugt.

Zur Herstellung in organischen Lösemitteln werden der Säurekatalysator, der Aldehyd und der Pfropf-Polyvinylalkohol in dem Lösemittel dispergiert oder gelöst und das Gemisch unter Rückfluß erhitzt. Gegebenenfalls kann der Aldehyd auch während des Reaktionsverlaufs zudosiert werden. Die in dem organischen Lösemittel unlöslichen Pfropf-Polyvinylalkohole gehen dabei mit fortschreitender Acetalisierung in Lösung.

Nach Beendigung der Acetalisierungsreaktion wird das Reaktionsprodukt durch Zusatz von unpolaren Lösemitteln, z. B. aliphatischen Kohlenwasserstoffen, oder durch Eingießen der Reaktionslösung in eiskaltes Wasser bzw. eiskaltes Wasser-Alkohol-Gemisch ausgefällt, abgesaugt, mit schwach alkalisch eingestelltem Wasser (pH 9 bis 12) gewaschen und getrocknet.

Die Herstellung der Pfropfpolyvinylacetale ist auch in der älteren deutschen Patentanmeldung P 38 35 840.9 beschrieben.

Die derart erhältlichen Polymeren ergeben in Kombination mit polymerisierbaren Verbindungen und Photoinitiatoren leicht und schleierfrei entwickelbare Schichten, die je nach Art der Zusammensetzung mit Wasser, wäßrigen Lösungen von anorganischen Salzen und/oder Tensiden oder mit wäßrig-alkalischen Lösungen entwickelt werden können. Die Schichten zeichnen sich durch hohe Abriebbeständigkeit, gute Farbannahme und praxisgerechte Lagerstabilität aus und sind daher für zahlreiche Anwendungsmöglichkeiten einsetzbar, insbesondere für die Herstellung von Flachdruckplatten, Siebdruckschablonen und Photoresists.

Die photopolymerisierbaren Gemische enthalten im allgemeinen 20 bis 90, bevorzugt 30 bis 75 Gew.-% polymeres Bindemittel, bezogen auf das Gewicht aller nichtflüchtigen Bestandteile des Gemischs. Bis zu 50, vorzugsweise bis zu 20 Gew.-%, der Gesamtmenge an Bindemittel können durch eine Vielzahl herkömmlicher Bindemittel ersetzt werden. Als Beispiele seien genannt:
Polyamide, Polyvinylester, Polyvinylacetale, Polyvinylether, Epoxidharze, Polyacrylsäureester, Polymethacrylsäureester, Polyester, Alkydharze, Polyacrylamide, Polyvinylalkohole, Polyethylenoxide, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit Vorteil sollten auch diese Bindemittel wasserunlöslich, aber in wäßrig-alkalischen Lösungen löslich oder mindestens quellbar sein. Beispiele für derartige Polymere sind: Maleinatharze, Polymerisate aus N-(p-Tolyl-sulfonyl)-carbaminsäure-β-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate, Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u.a..

Die erfindungsgemäßen Gemische und Materialien enthalten radikalisch polymerisierbare Verbindungen mit mindestens einer endständigen ethylenischen Doppelbindung. Als polymerisierbare Verbindungen werden bevorzugt Ester der Acryl- oder Methacrylsäure mit ein- oder mehrwertigen, vorzugsweise primären Alkoholen verwendet. Vorzugsweise sollten die polymerisierbaren Verbindungen mehr als eine, insbesondere 2 bis 4, polymerisierbare Gruppen enthalten. Beispiele für geeignete mehrwertige Alkohole sind Ethylenglykol, Propylenglykol, Butandiol-1,4, Butandiol-1,3, Diethylenglykol, Triethylenglykol oder Polyethylen- oder Polypropylenglykole mit Molekulargewichten von etwa 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Besonders geeignet sind Urethangruppen enthaltende Bisacrylate und Bismethacrylate, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben. Zusätzlich zu den genannten Estern können auch Amide von Acryl- oder Methacrylsäure eingesetzt werden. Beispiele sind Methylenbis-(meth)acrylamid, Ethylenbis-(meth)acrylamid und m-Xylylenbis-(meth) acrylamid

Der Mengenanteil des Gemischs an Monomeren beträgt im allgemeinen etwa 10 bis 80, vorzugsweise 25 bis 70 Gew.-% der nichtflüchtigen Bestandteile.

Als Photoinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861 , der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxsysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)-4,6-bis-trichlormethyl-s-triazin. Diese Verbindungen können mit Vorteil mit photooxydierbaren Farbstoffen, photoreduzierbaren Verbindungen und ggf. weiteren Coinitiatoren kombiniert werden, wie es z. B. in den EP-A 284 939 und 287 817 beschrieben ist.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die photopolymerisierbaren Gemische können auch mit anderen negativ arbeitenden lichtempfindlichen Verbindungen, insbesondere mit Diazoniumsalz-Polykondensationsprodukten kombiniert werden. Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet.

Mit besonderem Vorteil werden Mischkondensationsprodukte verwendet, die außer den Diazoniumsalzeinheiten A-N₂X noch andere, nicht lichtempfindliche Einheiten B enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R¹-R²-)ₚR³-N₂X ab, wobei
- X: das Anion der Diazoniumverbindung,
- p: eine ganze Zahl von 1 bis 3,
- R¹: einen aromatischen Rest mit mindestens einer zur Kondensation mit aktiver Carbonylverbindung befähigten Position,
- R³: eine Arylengruppe, vorzugsweise eine ggf. substituierte Phenylengruppe,
- R²: eine Einfachbindung oder eine der Gruppen:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
- O -
- S - oder
-CO-NR⁴-
bedeuten, worin
- q: eine Zahl von 0 bis 5,
- r: eine Zahl von 2 bis 5,
- R⁴: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R⁵: eine Arylengruppe mit 6 bis 12 C-Atomen ist.

Weitere vorteilhafte Polykondensationsprodukte werden erhalten, indem ein ggf. substituiertes Diphenylamindiazoniumsalz zuerst mit einer aromatischen Verbindung R′-O-CH₂-B und danach mit einer aromatischen Verbindung R′-O-CH₂-B-CH₂-O-R′ kondensiert wird, wobei R′ ein Wasserstoffatom, ein Alkyl- oder aliphatischer Acylrest und B der Rest einer der vorstehend aufgezählten kondensationsfähigen Verbindungen ist. Diese Kondensationsprodukte sind in der EP-A 126 875 beschrieben.

Der Mengenanteil an Diazoniumsalz-Polykondensationsprodukten beträgt 0 bis 40, vorzugsweise 0 bis 30 Gew.-%, bezogen auf die nichtflüchtigen Bestandteile des Gemischs.

Die photopolymerisierbaren Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Victoriareinblau FGA, Victoriareinblau BO (C.I. 42595), Malachitgrün, Victoriablau B (C.I. 44045), Renolblau B2G-H (C.I. 74160), Kristallviolett, Fettrot 5B (C.I. 26125), Neozaponblau FLE (C.I. Solvent Blue 70), Brillantblausalz-Acetat, Samaronmarineblau, Orasolblau GN, Zaponechtfeuerrot B (C.I. [3900:1) oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Die Beschichtung des Trägermaterials erfolgt aus entsprechenden organischen Lösemitteln oder Lösemittelgemischen, und zwar im allgemeinen durch Gießen, Sprühen oder Eintauchen. Die Art des Auftrags hängt von der gewünschten Schichtdicke ab, wobei die Schichtdicken der trockenen Schicht im allgemeinen zwischen 0,5 und 200 µm liegen.

Als Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das erfindungsgemäße Gemisch erfordert nicht unbedingt einen Sauerstoffausschluß bei der Belichtung. Es ist aber im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Polyvinylalkohol, Vinylalkohol/Vinylacetat-Copolymere, Polyvinylpyrrolidon, Vinylpyrrolidon/Vinylacetat-Copolymere, Polyacrylsäure, Butadien/Maleinsäure-Copolymere, Polyvinylmethylether, Polyphosphate, Zucker usw.. Solche Deckschichten haben im allgemeinen eine Dicke von 0,1 bis 10, vorzugsweise von 0,5 bis 5 µm.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Bevorzugt wird das Gemisch zur Herstellung von Flachdruckformen verwendet, wobei als Trägermaterial Aluminium bevorzugt wird. Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxydation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch CO₂-Laser, welche bei 10,6 µm emittieren, oder YAG-Laser, die bei 1,06 µm emittieren.

Als Entwicklerlösungen werden neutrale oder bevorzugt alkalische wäßrige Lösungen mit einem pH-Wert im Bereich von 8 bis 14, vorzugsweise 8,5 bis 13, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösemitteln enthalten. Bevorzugt werden schwerflüchtige Lösemittel, z. B. araliphatische Alkohole, deren Dampfdruck bei der Handhabung des Entwicklers nicht ins Gewicht fällt. Die Entwicklung kann in bekannter Weise durch Tauchen, Besprühen, Bürsten oder Tamponieren erfolgen. Anschließend kann das entwickelte Material mit einem Konservierungsmittel behandelt werden.

Die erfindungsgemäßen lichtempfindlichen Aufzeichnungsmaterialien weisen gute Wiedergabeeigenschaften und praxisgerechte Lagerstabilität auf. Sie lassen sich leicht und schleierfrei mit Entwicklerlösungen verarbeiten, die praktisch umweltneutral sind.

Von besonderem Vorteil ist die hohe Druckauflage, die mit den aus dem erfindungsgemäßen Material hergestellten Druckformen erreicht wird sowie die gute Farbannahme. Die Druckschablonen weisen ebenfalls eine hohe Resistenz gegenüber alkalischen Entwicklern und anderen Verarbeitungslösungen auf. Zur weiteren Steigerung der Druckauflage können die Platten nach dem Belichten nacherwärmt und bzw. oder die entwickelten Platten nachbelichtet werden.

Im folgenden wird zunächst die Herstellung der in den Beispielen eingesetzten Polyvinylacetale beschrieben.
a) Herstellung von Polyurethan-Pfropfgrundlagen
   In einem Reaktionsgefäß mit Rührwerk wurden unter Stickstoffatmosphäre jeweils die Diolkomponente und der Katalysator vorgelegt, und das Gemisch wurde auf eine Reaktionstemperatur zwischen 65 und 100 °C erwärmt. Die Diisocyanatkomponente wurde anschliessend so zudosiert, daß die Temperatur des Reaktionsgemischs 120 °C, vorzugsweise 100 °C, nicht überschritt. Nach vollständiger Zudosierung der Diisocyanatkomponente wurde zur Vervollständigung der Reaktion bis zu zwei Stunden auf 80 bis 100 °C nacherwärmt. Die Vollständigkeit des Umsatzes und damit das Ende der Reaktion wurden durch Analyse des Diisocyanatverbrauchs nach üblichen Methoden (z. B. IR-Spektroskopie, Titration) ermittelt.
   Einzelheiten über die Zusammensetzung der Reaktionsgemische der Beispiele sowie das berechnete mittlere Molekulargewicht (M̅_{ber}) der resultierenden Polyurethane (PU) können der Tabelle 1 entnommen werden. Die Molekulargewichte ergeben sich aus dem Molverhältnis Diolkomponente/Diisocyanat unter der Annahme einer vollständigen Umsetzung der NCO-Gruppen.

**Tabelle 1**

| Polyurethan (PU) | Diolkomponente PEG/Bu (Molverhältnis) | Reaktionstemp. °C | Molverhältnis Diolkomponente/Diisocyanat | M̅_{ber} |
|---|---|---|---|---|
| A | 7 : 3 | 80 | 1 : 0,9 | 6470 |
| B | 7 : 3 | 72 | 1 : 0,9 | 6470 |
| C | 3 : 2 | 78 | 1 : 0,97 | 18300 |
| D | 7 : 3 | 75 | 1 : 0,97 | 19900 |
| E | 7 : 3 | 78 | 1 : 0,95 | 13200 |

Alle Produkte wurden mit Isophorondiisocyanat als Diisocyanatkomponente hergestellt. Als Katalysator wurde bei allen Produkten 1,4-Dimethylpiperazin in einer Menge von 0,48 mol-%, bezogen auf Diisocyanat, eingesetzt.
PEG = Polyethylenglykol, Molgewicht 600
Bu = 1,4-Butandiol
b) Herstellung der Pfropfpolymeren
   Die Polyurethan-Pfropfgrundlage wurde jeweils in einem Reaktionsgefäß unter Stickstoffatmosphäre aufgeschmolzen bzw. unter Zusatz geringer Mengen Methanol gelöst und auf eine Temperatur von etwa 60 bis 100 °C erwärmt. Die zu pfropfenden Monomeren wurden, ggf. gelöst in einem Lösemittel (z. B. Methanol), einschließlich des in den Monomeren gelösten radikalischen Initiators so langsam zu der Polyurethan-Pfropfgrundlage dosiert, daß die Bildung von Homopolymerisat weitgehend unterblieb.
   Die Temperatur des Reaktionsgemischs sollte 120 °C, besser noch 100 °C nicht überschreiten. Nach Beendigung der Nachreaktion wurde überschüssiges Restmonomeres durch azeotrope Destillation mit Methanol entfernt. Die Zusammensetzung der einzelnen Reaktionsgemische sowie die Reaktionsparameter sind in Tabelle 2 angegeben.

**Tabelle 2**

| Pfropfpolymeres | PU | VAc g/g PU | Cr g/g PU | Start Temp. °C | Zudos-Zeit Min. | Nachreakt. Min. | Gepfr. Monom. Gew.-% | Jₒ ml/g | Berechnetes Mol-Gew. |
|---|---|---|---|---|---|---|---|---|---|
| AV | A | 4 | 0 | 75 | 420 | 45 | 79,8 | 21,9 | 31300 |
| BV | B | 2,32 | 0 | 73 | 420 | 45 | 69,3 | 18,3 | 21000 |
| CV | C | 3,16 | 0 | 75 | 300 | 45 | 74,7 | 26,3 | 72500 |
| DV | D | 3,16 | 0 | 75 | 420 | 45 | 74,5 | 28,7 | 78000 |
| EVCr | E | 3,03 | 0,126 | 75 | 300 | 45 | 75,3 | 31,5 | 53000 |
| VAc = Vinylacetat Jₒ = Grenzviskositätszahl (intrinsic viscosity) Cr = Crotonsäure | | | | | | | | | |

Alle Produkte wurden unter Verwendung von 0,2 mol-% Dibenzoylperoxid (bezogen auf das eingesetzte Monomere) hergestellt. Die Grenzviskositätszahlen wurden im Ostwaldviskosimeter in Tetrahydrofuran bei 25 °C ermittelt, die vermessenen Konzentrationen wurden so gewählt, daß eine Hagenbachkorrektur nicht durchgeführt werden mußte. Die gepfropfte Monomermenge in Gew.-% bezieht sich auf das Gewicht des Gesamtpolymeren.
c) Verseifung der Pfropfpolymeren
   Die Pfropfpolymerisate aus Tabelle 2 wurden innerhalb zwei Stunden bei Raumtemperatur umgeestert bzw. verseift. Hierzu wurden die Produkte zu 50 %iger Lösung in Methanol gelöst und mit methanolischer Natronlauge (10 %ig) versetzt. Es wurden je nach Alkalimenge und dem Pfropfungsgrad des Pfropfpolymerisats polymere Hydrolyseprodukte mit unterschiedlichem Hydrolysegrad erhalten. Die erhaltenen Gele wurden mittels üblicher Mühlen granuliert, das Granulat mit Methanol gewaschen (ggf. unter Zusatz von Essigsäure zur Neutralisation der Natronlauge) und getrocknet. Die Verfahrensbedingungen und Ergebnisse sind in Tabelle 3 aufgeführt.

**Tabelle 3**

| Pfropfpolyvinylalkohol | Pfropfpolyvinylacetat | mol-% NaOH je Estereinheit | Hydrolysegrad in % | M̅_{ber} |
|---|---|---|---|---|
| F | AV | 1,92 | 98,2 | 22 000 |
| G | BV | 5,0 | 98,9 | 14 000 |
| H | CV | 1,92 | 98 | 47 000 |
| I | DV | 1,97 | 98,4 | 44 000 |
| K | EVCr | 2,0 | 94,5* | 36 000 |

| | | | | |
|---|---|---|---|---|
| * ermittelt durch Bestimmung der nach der Verseifung vorhandenen Säure; dabei wird auch die im Polymeren enthaltene Crotonsäure erfaßt. | | | | |

d) Herstellung der Pfropf-Polyvinylacetale
   Die Pfropfpolymerisate aus Tabelle 3 werden unter leichtem Erwärmen in etwa der achtfachen Menge destillierten Wassers gelöst. Bei Raumtemperatur wird die entsprechende Menge Aldehyd und eine geringe Menge 2,6-Di-tert.-butyl-4-methyl-phenol zugegeben. Zu dieser Lösung wird unter gutem Rühren eine Lösung aus einer kleinen Menge Natriumoctylsulfat, 1/3 der Gewichtsmenge des Aldehyds an konzentrierter Salzsäure und Wasser zugetropft. Nach einer Stunde Rühren bei Raumtemperatur wird auf 40 °C erwärmt und noch 2 Stunden gerührt. Dann wird nochmals konzentrierte Salzsäure in gleicher Gewichtsmenge wie der Aldehyd zugesetzt und weitere 2 Stunden bei 40 °C gerührt. Nach Abkühlen auf Raumtemperatur wird die wäßrige Phase vom ausgefallenen Polymeren abdekantiert, das Polymere in Ethanol gelöst und durch Eingießen in einen Überschuß Wasser ausgefällt. das Polymere wird im Vakuumtrockenschrank bei 40 °C zur Gewichtskonstanz getrocknet.

**Tabelle 4**

| Pfropfpolyvinylacetal | Pfropfpolyvinylalkohol | Aldehyd | OH-Zahl |
|---|---|---|---|
| L | F | Pr+4-ClBz 3) | 302 |
| M | G | Bu | 290 |
| N | H | Pr | 336 |
| O | I | i-Bu | 268 |
| P | K | Bu | 401 |
| Q | I | 4-CH₃OBz+Bu 1) | 214 |
| R | H | Pr+Bu 2) | 312 |
| Bu = n-Butyraldehyd i-Bu = Isobutyraldehyd 4-CH₃OBz = 4-Methoxy-benzaldehyd 4-ClBz = 4-Chlor-benzaldehyd Pr = Propionaldehyd | | | |

| | | | |
|---|---|---|---|
| 1) Molverhältnis 1 : 3 | | | |
| 2) Molverhältnis 1 : 2 | | | |
| 3) Molverhältnis 3 : 4 | | | |

Die folgenden Beispiele erläutern bevorzugte Ausführungsformen der Erfindung. Die Mengen sind zumeist in Gewichtsteilen (Gt) angegeben. Prozentangaben und Mengenverhältnisse sind in Gewichtseinheiten zu verstehen, wenn nichts anderes angegeben ist.

### Beispiel 1

Eine Beschichtungslösung aus
1,2 Gt des Polymeren N,
1,0 Gt eines technischen Gemisches aus Pentaerythrittri- und -tetraacrylat,
0,15 Gt 2-(p-Trichlormethyl-benzoylmethylen)-3-ethyl-benzthiazolin und
0,03 Gt eines blauen Azofarbstoffs, erhalten durch Kuppeln von 2,4-Dinitro-6-chlor-benzoldiazoniumsalz mit 2-Methoxy-5-acetylamino-N-cyanoethyl-N-hydroxyethyl-anilin in
50,00 Gt 2-Methoxy-ethanol
wurde auf eine 0,3 mm starke, in Salpetersäure elektrochemisch aufgerauhte, in Schwefelsäure anodisierte und mit einer 0,1 %igen wäßrigen Lösung von Polyvinylphosphonsäure nachbehandelte Aluminiumfolie derart aufgebracht, daß ein Trockenschichtgewicht von 1,1 g/m² erhalten wurde. Anschließend wurde die Platte mit einer 3,5-prozentigen wäßrigen Lösung von Polyvinylalkohol (12 % Restacetylgruppen, K-Wert 4) beschichtet. Nach dem Trocknen wurde eine Deckschicht mit einem Gewicht von 0,8 g/m² erhalten. Die erhaltene Druckplatte wurde mittels einer 5 kW-Metallhalogenidlampe im Abstand 110 cm 40 Sekunden unter einem 13-stufigen Belichtungskeil mit Dichteinkrementen von 0,15 belichtet, auf den zusätzlich ein Silberfilm mit gleichmäßiger Schwärzung (Dichte 1,57) und gleichmäßiger Absorption über den wirksamen Spektralbereich als Graufilter montiert war. Nach der Belichtung wurde die Platte mit einem Entwickler folgender Zusammensetzung mittels eines Plüschtampons behandelt.
5,0 Gt Natriumoctylsulfat und
1,0 Gt Natriummetasilikat x 5 Wasser in
94,0 Gt dest. Wasser.

Die nichtbelichteten Schichtbereiche wurden innerhalb weniger Sekunden sauber entfernt. In der Kopie war die Stufe 4 des Stufenkeils noch voll wiedergegeben; ebenso wie die feinsten Elemente der Vorlage.

### Beispiel 2

Aus 1,0 Gt des Polymeren M,
1,5 Gt Trimethylolethantriacrylat,
0,2 Gt 2,4-Bis-trichlormethyl-6-(4-styrylphenyl)-s-triazin und
0,015 Gt Kristallviolett (C.I. 42555) in
50,0 Gt 2-Methoxy-ethanol
wurde eine Beschichtungslösung hergestellt, die auf den Schichtträger aus Beispiel 1 so aufgebracht wurde, daß ein Trockenschichtgewicht von 1,5 g/m² erhalten wurde.

Anschließend wurde analog zu Beispiel 1 eine Deckschicht von 0,6 g/m² aufgebracht. Belichtung und Entwicklung erfolgten wie in Beispiel 1; die Belichtungszeit betrug jedoch nur 18 Sekunden.

### Beispiel 3

In der Beschichtungslösung von Beispiel 1 wurde das Polymere N durch die gleiche Menge des Polymeren P ersetzt und auf den Schichtträger aus Beispiel 1 aufgebracht. Das Trockenschichtgewicht betrug 1,3 g/m². Das Schichtgewicht der Deckschicht wurde auf 0,8 g/m² eingestellt. Belichtung und Entwicklung wurden analog zu Beispiel 1 durchgeführt. Man erhielt eine Kopie mit sehr hoher Auflösung und guter Farbannahme.

### Beispiel 4

Aus 1,56 Gt des Polymeren L,
0,91 Gt eines Diazoniumsalz-Polykondensationsprodukts aus 1 mol 3-Methoxy-diphenylamin-4-diazoniumsulfat und 1 mol 4,4′-Bis-methoxymethyl-diphenylether, isoliert als Mesitylensulfonat,
0,049 Gt Phosphorsäure (85 %ig),
0,162 Gt 2-(4-Methoxystyryl)-4,6-bis-trichlormethyl-s-triazin,
1,75 Gt eines technischen Gemischs aus Pentaerythrittri- und -tetraacrylat und
0,55 Gt des in Beispiel 1 angegebenen Azofarbstoffs in
70,0 Gt Butanon,
4,0 Gt Ethanol und
2,0 Gt Butylacetat
wurde eine Lösung hergestellt, die auf eine elektrochemisch aufgerauhte, anodisierte und mit Polyvinylphosphonsäure behandelte Aluminiumfolie aufgetragen und zu einem Schichtgewicht von 2,1 g/m² getrocknet wurde.

Die Schicht wurde durch eine Negativvorlage 25 Sekunden belichtet, wobei man eine gedeckte Stufe 4 erhielt. Die Entwicklung wurde mit einer Entwicklerlösung folgender Zusammensetzung vorgenommen:
5,0 Gt Natriumoctylsulfat,
1,5 Gt Natriummetasilikat x 5 Wasser und
1,0 Gt Trinatriumphosphat x 12 Wasser in
92,5 Gt dest. Wasser.

Nach dem Einspannen der Druckform in eine Bogenoffsetmaschine konnte beobachtet werden, daß die Druckplatte die angebotene Farbe sehr rasch annahm. Es wurden 280.000 gute Drucke erhalten.

### Beispiel 5

Aus 2,5 Gt des Polymeren O,
5,6 Gt eines technischen Gemischs aus Pentaerythrittri- und -tetraacrylat,
0,2 Gt des in Beispiel 4 angegebenen Triazins und
0,03 Gt des in Beispiel 1 angegebenen Azofarbstoffs in
25 Gt Butanon,
2 Gt Ethanol und
1 Gt Butylacetat
wurde eine Lösung bereitet, die auf eine biaxial verstreckte und thermofixierte Polyethylenterephthalatfolie der Stärke 25 µm so aufgeschleudert wurde, daß nach dem Trocknen bei 100 °C ein Trockenschichtgewicht von 35 g/m² erhalten wurde. Die derart hergestellte Trockenresistfolie wurde mit einer Laminiervorrichtung bei 120 °C auf eine mit 35 µm starker Kupferfolie kaschierte Phenoplast-Schichtstoffplatte laminiert und 25 Sekunden unter einem handelsüblichen Belichtungsgerät belichtet. Als Vorlage diente eine Strichvorlage mit Linienbreiten und Abständen bis herab zu 80 µm. Nach der Belichtung wurde die Polyesterfolie langsam abgezogen und die erhaltene Schicht mit einem Entwickler folgender Zusammensetzung
5,0 Gt Natriumoctylsulfat,
1,5 Gt Natriummetasilikat x 5 Wasser,
1,5 Gt Dinatriumhydrogenphosphat x 12 Wasser in
92,0 Gt dest. Wasser
in einem Sprühentwicklungsgerät 90 Sekunden entwickelt. Anschließend wurde 30 Sekunden mit Leitungswasser gespült, 30 Sekunden in einer 15 %igen Ammoniumperoxydisulfatlösung angeätzt und anschließend in folgenden Elektrolytbädern galvanisiert:
1. 30 Minuten in einem Kupferbad der Fa. Schlötter, Geislingen/Steige, Typ "Glanzkupfer-Bad".
   Stromdichte: 2,5 A/cm^{2.}
   Metallaufbau: ca. 12,5 µm.
2. 30 Minuten in einem Nickelbad des gleichen Herstellers, Typ "Norma".
   Stromdichte: 4,0 A/cm².
   Metallaufbau: 9 µm.

Die Platte zeigte keine Beschädigungen oder Unterwanderungen. Die Entschichtung erfolgte in 5-%iger KOH-Lösung bei 50 °C. Das freigelegte Kupfer wurde mit den üblichen Ätzmedien weggeätzt.

### Beispiel 6

Eine Beschichtungslösung aus
1,0 Gt des Polymeren Q,
1,0 Gt eines technischen Gemisches aus Pentaerythrit-tri- und -tetraacrylat,
0,10 Gt 2,4-Bis-trichlormethyl-6-(4-ethoxy-naphth-1-yl)-s-triazin und
0,02 Gt Victoriareinblau FGA (C.I. Basic Blue 81) in
50,0 Gt Propylenglykolmonomethylether
wurde auf eine elektrochemisch aufgerauhte, anodisierte und mit Polyvinylphosphonsäure nachbehandelte Aluminiumfolie aufgetragen und zu einem Schichtgewicht von 1,3 g/m² getrocknet. Die erhaltene Druckplatte wurde unter einer Testvorlage belichtet und mit dem in Beispiel 5 angegebenen Entwickler entwickelt.

Die Druckform nahm in der Bogenoffsetmaschine sofort fette Farbe an. Auch nach längerem Maschinenstillstand wurde die Farbe bereits nach 2 bis 8 Bögen wieder voll angenommen. Die erzielte Druckauflage betrug 95.000 einwandfreie Drucke, wobei auch feinste Linien noch voll wiedergegeben wurden.

Vier der so hergestellten Platten wurden 1 bis 4 Stunden in einem Trockenschrank bei 100 °C gelagert. Nach der Wärmebehandlung wurden die Platten bildmäßig belichtet und mit dem oben angegebenen Entwickler entwickelt. Zum Sichtbarmachen von verbleibenden Schichtresten (Ton) in den Nichtbildstellen wurden die getrockneten Platten mit Schutzfarbe eingefärbt.

Die eine und zwei Stunden gelagerten Platten ließen sich einwandfrei entwickeln. Sie zeigten keine nennenswerte Verkürzung des Halbtonstufenkeils. Nach dreistündiger Wärmelagerung zeigte die Schicht eine Verkürzung des Halbtonstufenkeils um eine Stufe. Die Entwicklung war nur leicht verzögert. Die vier Stunden gelagerte Platte ließ sich nur geringfügig verzögert entwickeln. Die Ergebnisse zeigen, daß die erfindungsgemäßen Gemische gegen Lagerung in der Wärme relativ beständig sind.

### Beispiel 7

Eine Beschichtungslösung aus
2,28 Gt des Polymeren R,
2,28 Gt Pentaerythrittriacrylat,
0,010 Gt Phenylazodiphenylamin,
0,211 Gt des in Beispiel 2 angegebenen Triazins,
0,35 Gt Renolblau B2G-H (C.I. 74160),
70,0 Gt Propylenglykolmonomethylether
wurde auf den Träger aus Beispiel 1 so aufgebracht, daß ein Trockenschichtgewicht von 2,5 g/m² erhalten wurde. Die lichtempfindliche Schicht wurde unter einer Standard-Negativvorlage 12 Sekunden mit einer Metallhalogenid-Lampe von 5 kW Leistung belichtet. Die lichtempfindliche Schicht, die eine deutliche Differenzierung der belichteten und unbelichteten Schichtbereiche aufwies, wurde mit der Entwicklerlösung aus Beispiel 5 mittels eines Plüschtampons behandelt, wobei die nichtbelichteten Schichtbereiche innerhalb von 10 Sekunden nach der Benetzung durch die Entwicklerflüssigkeit entfernt wurden. Anschließend wurde mit Wasser abgespült und getrocknet.

In der Kopie war die Stufe 4 eines Silberfilm-Halbtonstufenkeils mit einem Dichteumfang von 0,05 bis 3,05 und Dichteinkrementen von 0,15 voll abgebildet. Auch feinste Raster und Linien der Vorlage wurden klar wiedergegeben.

Auf die oben hergestellte Druckplatte wurde eine Schicht von Polyvinylalkohol (12 % Restacetylgruppen, K-Wert 4) so aufgebracht, daß ein Trockenschichtgewicht von 0,8 g/m² erhalten wurde. Das Aufbringen der Sauerstoffsperrschicht auf die lichthärtbare Schicht erhöhte die Lichtempfindlichkeit um 30 %. Wenn beide Platten in eine Bogenoffsetmaschine eingespannt wurden, so zeigte sich, daß durch die Deckschicht auch eine Steigerung der Druckauflage, und zwar um ca. 250 %, erreicht wurde.

### Beispiel 8

Die in Beispiel 7 hergestellten Druckplatten (mit und ohne Sauerstoffsperrschicht) wurden nach dem Belichten eine Minute bei 100 °C behandelt und anschließend entwickelt. Im Vergleich zu den nicht nacherwärmten Druckplatten aus Beispiel 7 wurden jeweils zwei gedeckte Stufen mehr erhalten.

Auch die Druckauflage kann durch die Nacherwärmung erhöht werden; bei der Platte ohne Deckschicht um ca. 200 %, bei der Platte mit Deckschicht um 100 %. Dieselbe Steigerung der Auflagenbeständigkeit kann durch Nachbelichten erreicht werden.

## Patentansprüche

1. Photopolymerisierbares Gemisch, das als wesentliche Bestandteile
a) ein polymeres Bindemittel mit wiederkehrenden Vinylacetaleinheiten,
b) eine radikalisch polymerisierbare Verbindung mit mindestens einer endständigen ethylenisch ungesättigten Gruppe und einem Siedepunkt bei Normaldruck oberhalb 100 °C und
c) eine Verbindung oder eine Verbindungskombination enthält, die unter Einwirkung von aktinischem Licht die Polymerisation der Verbindung (b) einzuleiten vermag,
dadurch gekennzeichnet, daß das Bindemittel ein Pfropfmischpolymerisat ist, dessen Pfropfgrundlage ein Polyurethan mit aufgepfropften Ketten ist, die Vinylalkohol- und Vinylacetaleinheiten enthalten.

2. Photopolymerisierbares Gemisch nach Anspruch 1, dadurch gekennzeichnet, daß die aufgepfropften Ketten ferner Vinylestereinheiten enthalten.

3. Photopolymerisierbares Gemisch nach Anspruch 1, dadurch gekennzeichnet, daß die Vinylacetaleinheiten von einem aliphatischen oder cycloaliphatischen Aldehyd abgeleitet sind.

4. Photopolymerisierbares Gemisch nach einem der Ansprüche 1 bis 3, dadurch gekennzeichnet, daß die aufgepfropften Ketten ferner Einheiten von weiteren ethylenisch ungesättigten, mit Vinylestern copolymerisierbaren Monomeren enthalten.

5. Photopolymerisierbares Gemisch nach Anspruch 1, dadurch gekennzeichnet, daß das Polyurethan ein Polyadditionsprodukt aus Diisocyanaten und Diolen ist.

6. Photopolymerisierbares Gemisch nach Anspruch 5, dadurch gekennzeichnet, daß als Diol ein aliphatisches Diol mit 2 bis 12 Kohlenstoffatomen, ein cycloaliphatisches Diol mit 5 bis 10 Kohlenstoffatomen oder ein aliphatisches Polydiol mit einem Molekulargewicht von 200 bis 10.000 eingesetzt wird.

7. Photopolymerisierbares Gemisch nach Anspruch 6, dadurch gekennzeichnet, daß als Diol ein Gemisch aus 1 mol Polydiol und 0,1 bis 0,7 mol niedermolekularem aliphatischem Diol eingesetzt wird.

8. Photopolymerisierbares Gemisch nach Anspruch 5, dadurch gekennzeichnet, daß das Diisocyanat ein aliphatisches Diisocyanat mit 4 bis 15 Kohlenstoffatomen oder ein cycloaliphatisches Diisocyanat mit 7 bis 15 Kohlenstoffatomen ist.

9. Photopolymerisierbares Gemisch nach Anspruch 1 oder 5, dadurch gekennzeichnet, daß das Polyurethan ein Molekulargewicht von 200 bis 100.000 hat.

10. Photopolymerisierbares Gemisch nach Anspruch 1, dadurch gekennzeichnet, daß das Pfropfpolymerisat eine Hydroxylzahl im Bereich von 100 bis 600 aufweist.

11. Photopolymerisierbares Gemisch nach Anspruch 1, dadurch gekennzeichnet, daß die radikalisch polymerisierbare Verbindung ein Acryl- oder Methacrylsäureester eines ein- oder mehrwertigen Alkohols oder ein Acryl- oder Methacrylsäureamid ist.

12. Photopolymerisierbares Gemisch nach Anspruch 1, dadurch gekennzeichnet, daß es 20 bis 95 Gew.-% Pfropfpolymerisat, 5 bis 70 Gew.-% polymerisierbare Verbindungen und 0,1 bis 15 Gew.-% Photopolymerisationsinitiator enthält.

13. Photopolymerisierbares Gemisch nach Anspruch 1, dadurch gekennzeichnet, daß es zusätzlich ein Diazoniumsalz-Polykondensationsprodukt enthält.

14. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß einem der Ansprüche 1 bis 13 besteht.

## Claims

1. A photopolymerizable mixture which contains, as essential constituents,
a) a polymeric binder possessing repeating vinyl acetal units,
b) a free-radically polymerizable compound possessing at least one terminal ethylenically unsaturated group and having a boiling point of more than 100 °C at normal pressure, and
c) a compound or a combination of compounds which under the action of actinic light is capable of initiating the polymerization of compound b),
wherein said binder is a graft polymer obtained from a polyurethane graft backbone, onto which chains containing vinyl alcohol units and vinyl acetal units are grafted.

2. The photopolymerizable mixture as claimed in claim 1, wherein the grafted-on chains furthermore contain vinyl ester units.

3. The photopolymerizable mixture as claimed in claim 1, wherein the vinyl acetal units are derived from an aliphatic or cycloaliphatic aldehyde.

4. The photopolymerizable mixture as claimed in any of claims 1 to 3, wherein the grafted-on chains furthermore contain units of other ethylenically unsaturated monomers which are copolymerizable with vinyl esters.

5. The photopolymerizable mixture as claimed in claim 1, wherein the polyurethane is a polyaddition product obtained from diisocyanates and diols.

6. The photopolymerizable mixture as claimed in claim 5, wherein the diol is an aliphatic diol having 2 to 12 carbon atoms, a cycloaliphatic diol having 5 to 10 carbon atoms or an aliphatic polydiol having a molecular weight between 200 and 10,000.

7. The photopolymerizable mixture as claimed in claim 6, wherein the diol is a mixture comprising 1 mol of polydiol and 0.1 to 0.7 mol of low molecular weight aliphatic diol.

8. The photopolymerizable mixture as claimed in claim 5, wherein the diisocyanate is an aliphatic diisocyanate having 4 to 15 carbon atoms or a cycloaliphatic diisocyanate having 7 to 15 carbon atoms.

9. The photopolymerizable mixture as claimed in claim 1 or 5, wherein the polyurethane has a molecular weight between 200 and 100,000.

10. The photopolymerizable mixture as claimed in claim 1, wherein the graft polymer has a hydroxyl number in the range of 100 to 600.

11. The photopolymerizable mixture as claimed in claim 1, wherein the compound which can be polymerized by a free-radical process is an acrylate or methacrylate of a mono- or polyhydric alcohol or an acrylic or methacrylic acid amide.

12. The photopolymerizable mixture as claimed in claim 1, wherein 20 to 95 % by weight of graft polymer, 5 to 70 % by weight of polymerizable compounds and 0.1 to 15 % by weight of photopolymerization initiator are contained.

13. The photopolymerizable mixture as claimed in claim 1, wherein a diazonium salt polycondensation product is additionally contained.

14. A photopolymerizable recording material comprising a layer support and a photopolymerizable layer, wherein the photopolymerizable layer comprises a mixture as claimed in any of claims 1 to 13.

## Revendications

1. Composition photopolymérisable, qui contient en tant que composants essentiels
a) un liant polymère à motifs répétitifs acétal de vinyle,
b) un composé polymérisable par polymérisation radicalaire, comportant au moins un groupe terminal à insaturation éthylénique et ayant un point d'ébullition, sous la pression normale, de plus de 100°C, et
c) un composé ou une association de composés permettant d'amorcer, sous l'effet d'une lumière actinique, la polymérisation du composé (b),
caractérisée en ce que le liant est un copolymère greffé dont le support de greffe est un polyuréthanne à chaînes greffées qui contiennent des motifs alcool vinylique et acétal de vinyle.

2. Composition photopolymérisable selon la revendication 1, caractérisée en ce que les chaînes greffées contiennent en outre des motifs ester vinylique.

3. Composition photopolymérisable selon la revendication 1, caractérisée en ce que les motifs acétal de vinyle sont dérivés d'un aldéhyde aliphatique ou cycloaliphatique.

4. Composition photopolymérisable selon l'une des revendications 1 à 3, caractérisée en ce que les chaînes greffées contiennent en outre des motifs d'autres monomères à insaturation éthylénique, copolymérisables avec des esters vinyliques.

5. Composition photopolymérisable selon la revendication 1, caractérisée en ce que le polyuréthanne est un produit de polyaddition de diisocyanates et de diols.

6. Composition photopolymérisable selon la revendication 5, caractérisée en ce que, en tant que diol, on utilise un diol aliphatique ayant de 2 à 12 atomes de carbone, un diol cycloaliphatique ayant de 5 à 10 atomes de carbone ou un polydiol aliphatique ayant une masse moléculaire de 200 à 10 000.

7. Composition photopolymérisable selon la revendication 6, caractérisée en ce que, en tant que diol, on utilise un mélange de 1 mole de polydiol et de 0,1 à 0,7 mole d'un diol aliphatique à faible masse moléculaire.

8. Composition photopolymérisable selon la revendication 5, caractérisée en ce que le diisocyanate est un diisocyanate aliphatique ayant de 4 à 15 atomes de carbone ou un diisocyanate cycloaliphatique ayant de 7 à 15 atomes de carbone.

9. Composition photopolymérisable selon la revendication 1 ou 5, caractérisée en ce que le polyuréthanne a une masse moléculaire de 200 à 100 000.

10. Composition photopolymérisable selon la revendication 1, caractérisée en ce que le polymère greffé présente un indice d'hydroxy dans la plage de 100 à 600.

11. Composition photopolymérisable selon la revendication 1, caractérisée en ce que le composé polymérisable par polymérisation radicalaire est un ester acrylique ou méthacrylique d'un alcool mono- ou polyhydroxylé, ou un acryl- ou méthacrylamide.

12. Composition photopolymérisable selon la revendication 1, caractérisée en ce qu'elle contient de 20 à 95 % en poids de polymère greffé, de 5 à 70 % en poids de composés polymérisables et de 0,1 à 15 % en poids d'initiateur de photopolymérisation.

13. Composition photopolymérisable selon la revendication 1, caractérisée en ce qu'elle contient en outre un produit de polycondensation de sel de diazonium.

14. Matériau de reprographie photopolymérisable, comportant un support de couche et une couche photopolymérisable, caractérisé en ce que la couche photopolymérisable consiste en une composition selon l'une des revendications 1 à 13.
